# EUROPÄISCHE PATENTANMELDUNG

(11) **EP 4 075 927 A1**
(43) Veröffentlichungstag der Anmeldung: **19.10.2022**
(21) Anmeldenummer: 21167835.4
(22) Anmeldetag: 12.04.2021
(51) Int. Cl.: H05K 3/22

(54) **ELEKTRONIK-BAUGRUPPE MIT MEHREREN TEILELEMENTEN UND RECYCLING-VERFAHREN FÜR EINE ELEKTRONIK-BAUGRUPPE**

(71) Anmelder: Siemens Aktiengesellschaft, 80333 München (DE)
(72) Erfinder: Raab, Oliver, 94496 Ortenburg (DE); Stegmeier, Stefan, 81825 München (DE)

(57) **Zusammenfassung**

Es wird eine Elektronik-Baugruppe (1) mit einem ersten Teilelement (10) und einem zweiten Teilelement (20) angegeben. Die Elektronik-Baugruppe umfasst einen Verbindungsbereich (100), in dem die beiden Teilelemente (10,20) miteinander verbunden sind und der zumindest abschnittsweise eine Trennschicht (200) aufweist,
wobei die Trennschicht eine Reaktionsschicht (210) umfasst, die durch Zünden einer exothermen chemischen Reaktion reagieren kann, so dass die exotherme chemische Reaktion in der Trennschicht (200) zu einer Auftrennung der Elektronik-Baugruppe (1) in das erste Teilelement (10) und das zweite Teilelement (20) führt.

Weiterhin wird ein Verfahren zum Recyceln von wenigstens einer Teilkomponente einer solchen Elektronik-Baugruppe (1) angegeben.

## Beschreibung

Die vorliegende Erfindung betrifft eine Elektronik-Baugruppe mit einem ersten Teilelement und einem zweiten Teilelement und einem Verbindungsbereich, in dem die beiden Teilelemente miteinander verbunden sind. Weiterhin betrifft die Erfindung ein Verfahren zum Recyceln von wenigstens einer Teilkomponente einer solchen Elektronik-Baugruppe.

Viele Elektronik-Baugruppen umfassen wertvolle Rohstoffe, für die ein Recycling ökologisch und wirtschaftlich sinnvoll ist. Solche Rohstoffe sind zum Beispiel sogenannte Massenmetalle wie Kupfer und Eisen sowie Edelmetalle, weiterhin Keramik und Glas und zunehmend auch Kunststoffe. Neben diesen besonders wertvollen Rohstoffen sind in vielen Elektronik-Baugruppen aber auch Schadstoffe enthalten, die giftig bzw. umweltbelastend sind. Beispiele hierfür sind Cadmium, Blei, Quecksilber, aber auch Additive in Kunststoffen sowie Bestandteile, aus denen Treibhausgase freigesetzt werden können. Sowohl die wertvollen Rohstoffe als auch die Schadstoffe in den Elektronik-Baugruppen liefern eine starke Motivation dafür, diese Baugruppen einem separaten Recycling-Prozess zuzuführen und nicht einfach zusammen mit dem Hausmüll zu entsorgen.

Ein problematischer Aspekt bei vielen bekannten Elektronik-Baugruppen ist, dass darin häufig Verbundwerkstoffe eingesetzt werden oder dass die Baugruppen in anderer Weise aus mehreren stoffschlüssig verbundenen Teilelementen zusammengesetzt sind. Diese zusammengesetzten Baugruppen lassen sich beim Recycling nicht immer kontrolliert in die einzelnen Teilelemente zerlegen, was die Wiederverwendung der Rohstoffe bzw. die Abtrennung der Schadstoffe wesentlich erschwert. Die stoffschlüssige Verbindung zweier solcher Teilelemente kann zum Beispiel durch Löten, Kleben, Schweißen oder Herstellen einer chemischen Verbindung (insbesondere durch kovalente Bindung, metallische Verbindung oder van-der-Waals-Bindungen) erreicht werden. So können zum Beispiel Halbleiter-Chips und andere elektrische Bauelemente wie Widerstände, Kondensatoren oder Spulen auf einen Schaltungsträger aufgelötet, aufgesintert oder mit einem leitfähigen Kleber geklebt sein. Auch können solche Chips oder anderen Bauteile zusätzlich zu ihrer elektrisch leitenden Anbindung verklebt, umhüllt oder unterfüllt sein, z.B. mit einem Glob-Top, einem Silikon oder einem Underfill-Material. Weiterhin können Halbleiter-Chips in sogenannte Mold-Gehäuse integriert sein und/oder sie können mit zusätzlichen Metallisierungsschichten versehen sein bzw. mit zusätzlichen organisch-isolierenden Verdrahtungsebenen versehen sein. Auch bei klassischen Leiterplatten (z.B. auf FR4-Basis) sind Glasfasern in Epoxidharz eingebettet, und es sind metallische Leiterbahnen (z.B. aus Kupfer oder Aluminium) mit den Kunststoffschichten laminiert und verklebt. Als weiteres Beispiel für einen schwer zu trennenden Materialverbund seien noch Folien-Akkumulatoren genannt, bei denen Lithium-haltige Materialien in ein Laminat aus Polymerfolien eingebettet sind.

Alle diese Beispiele verdeutlichen, dass es bei komplexeren Elektronik-Baugruppen oft schwer ist, diese in ihre Teilelemente zu zerlegen und gegebenenfalls aus den Teilelementen einzelne Materialkomponenten gezielt herauszutrennen. Bisher wird die Zerlegung von solchen Baugruppen durch ein Bündel von zur Verfügung stehenden Maßnahmen ermöglicht, die jedoch aufgrund des hohen Aufwands nur für einen relativ geringen Anteil des vorhandenen Elektroschrotts eingesetzt werden: So können die Elektronik-Baugruppen manuell zerlegt werden, und insbesondere Schadstoffe können manuell entfernt werden. Dies ist aber sehr aufwendig und kann die Gesundheit des Personals gefährden. Alternativ können die Baugruppen maschinell mechanisch zerkleinert (z. B. geschreddert) werden. Alternativ oder im Anschluss daran können physikalische und chemische Trennverfahren zum Einsatz kommen. So können zum Beispiel metallische Komponenten wie Gold, Kupfer, Kobalt oder Lithium physikalisch oder chemisch aus einem Materialverbund herausgelöst werden. Die Kunststoff-Bestandteile werden außerdem zum Teil thermisch verwertet.

Häufig beschränkt sich das Recycling bei Elektro-Altgeräten jedoch auf sogenannte Massenmetalle wie Eisen, Stahl, Kupfer und Aluminium und die wertvollen Edelmetalle. Andere Komponenten, die einen geringeren Materialanteil aufweisen oder weniger wertvoll sind, werden oft nicht zurückgewonnen, obwohl dies ökologisch sinnvoll wäre. Aufgrund der immer stärker werdenden Umweltbelastung durch Elektronikschrott, der steigenden Rohstoffpreise und auch der zunehmenden Komplexität der Baugruppen und ihrer stetig steigenden Menge besteht daher ein Bedarf für neue Technologien, die ein einfacheres und konsequenteres Recycling der im Elektronikschrott enthaltenen Materialien ermöglichen. Durch neuartige Elektronikprodukte wie smarte Möbel oder Textilien wird diese bestehende Problematik noch verstärkt.

Aufgabe der Erfindung ist es daher, eine Elektronik-Baugruppe anzugeben, welche die genannten Nachteile überwindet. Insbesondere soll eine Elektronik-Baugruppe zur Verfügung gestellt werden, welche mit vergleichsweise geringem Aufwand ein Recycling der enthaltenen Materialkomponenten ermöglicht.

Eine weitere Aufgabe ist es, ein Verfahren zum Recyclen von zumindest einer Teilkomponente einer solchen Elektronik-Baugruppe anzugeben.

Diese Aufgaben werden durch die in Anspruch 1 beschriebene Elektronik-Baugruppe und das in Anspruch 15 beschriebene Recycling-Verfahren gelöst.

Die erfindungsgemäße Elektronik-Baugruppe umfasst zumindest ein erstes und ein zweites Teilelement. Sie umfasst außerdem einen Verbindungsbereich, in dem die beiden Teilelemente miteinander verbunden sind und der zumindest abschnittsweise eine Trennschicht aufweist. Diese Trennschicht umfasst eine Reaktionsschicht, die durch Zünden einer exothermen chemischen Reaktion reagieren kann, wobei die exotherme chemische Reaktion in der Trennschicht zu einer Auftrennung der Elektronik-Baugruppe in das erste Teilelement und das zweite Teilelement führt. Unter dem Verbindungsbereich soll also ein Übergangsbereich zwischen den beiden Teilelementen der Baugruppe verstanden werden, in welchem insbesondere eine stoffschlüssige Verbindung vorliegen kann. Zumindest ein Teil dieses Verbindungsbereichs soll die beschriebene Trennschicht aufweisen, deren Funktionalität darin besteht, nach einer Aktivierung eine Trennung in die beiden Teilelemente zu ermöglichen. Der Verbindungsbereich kann also auch Teilbereiche ohne diese funktionale Trennschicht aufweisen. Wesentlich ist nur, dass die Trennschicht zumindest in einem oder mehreren Teilbereichen (und damit abschnittsweise) vorliegt. Dabei soll der Teilbereich bzw. die Teilbereiche mit der Trennschicht so ausgedehnt sein, dass die beschriebene Auftrennung der Baugruppe in die Teilelemente durch die Funktionalität der Trennschicht ermöglicht wird. Dabei soll auch nicht ausgeschlossen sein, dass die Baugruppe auch noch mehr als die genannten zwei Teilelemente aufweist. Optional können dann auch weitere Teilelemente über analog ausgestaltete Verbindungsbereiche (mit entsprechenden Trennschichten) mit dem ersten und/oder zweiten Teilelement auf die beschriebene Weise verbunden sein.

Die Trennschicht umfasst zumindest die genannte Reaktionsschicht. Sie kann optional auch noch ein oder mehrere weitere Schichten als Teil eines übergeordneten Schichtsystems umfassen. Die Reaktionsschicht ist so aufgebaut, dass in ihr eine exotherme chemische Reaktion gezündet werden kann. Hierzu kann die Reaktionsschicht zwei oder mehr Materialkomponenten aufweisen, welche miteinander in einer exothermen Reaktion reagieren können. Prinzipiell kann aber auch schon eine Materialkomponente ausreichen, welche als einziges Edukt durch Zünden exotherm reagieren kann. In jedem Fall soll die Reaktionsschicht so ausgestaltet sein, dass die exotherme chemische Reaktion zu einer Auftrennung der Baugruppe in die Teilelemente führt. Diese Auftrennung kann insbesondere durch die thermische Wirkung der exothermen Reaktion auf die benachbarten Elemente bzw. Schichten oder Schichtgrenzen ausgelöst werden. So kann durch die bei der Reaktion freigesetzte Wärme insbesondere eine im Verbindungsbereich vorliegende stoffschlüssige Verbindung gelöst werden. Dies kann durch ein Aufschmelzen oder Veraschen einer im Verbindungsbereich optional vorliegenden Kopplungsschicht geschehen oder aber auch durch thermisch verursachte Spannungen und dadurch verursachte Rissbildung bzw. Delamination und/oder eine verringerte Haftung bei einer höheren Temperatur. Vorteilhaft ist die Reaktionsschicht so ausgebildet, dass eine Zündung der exothermen Reaktion beim normalen Betrieb der Elektronik-Baugruppe vermieden wird. Dies kann insbesondere durch eine ausreichend hohe Zündschwelle erreicht werden, also beispielsweise durch eine ausreichend hohe Zündtemperatur bei einer thermisch induzierten Zündung bzw. durch eine ausreichend hohe Zündleistung bei einer elektrischen bzw. optischen Zündung mit einem entsprechenden Zündpuls. Die Reaktionsschicht soll aber "reaktiv" sein in dem Sinne, dass nach einer Aktivierung eine exotherme chemische Reaktion innerhalb der Reaktionsschicht selbständig weiterlaufen kann. Die exotherme chemische Reaktion pflanzt sich also insbesondere von einem Teilbereich der Reaktionsschicht, in dem sie gezündet wurde, in die übrigen Bereiche der Schicht fort. Diese Fortpflanzung beruht darauf, dass die Reaktionswärme der exothermen chemischen Reaktion aus einem bereits reagierten Bereich die nötige Aktivierungsenergie für die angrenzenden, noch nicht reagierten Bereiche der Reaktionsschicht liefert.

Ein wesentlicher Vorteil der erfindungsgemäßen Elektronik-Baugruppe liegt darin, dass innerhalb eines Recycling-Prozesses eine gezielte Zündung der exothermen chemischen Reaktion ermöglicht wird, wodurch die Baugruppe leicht in die Teilelemente zerlegbar ist. Diese Zündung kann insbesondere maschinell erfolgen und kann so automatisiert werden, dass kein manueller Arbeitsschritt für die Zerlegung nötig ist. Besonders leicht ist dies bei einer thermisch induzierten Zündung zu erreichen, bei der die Baugruppe lediglich auf eine ausreichend hohe Temperatur (ggf. mit ausreichend hohem Temperaturgradienten) erhitzt werden muss. Alternativ kann aber auch mit anderen Maßnahmen gezündet werden, welche sich ebenfalls für eine maschinelle bzw. automatisierte Umsetzung eignen, wie weiter unten beschrieben.

Insgesamt wird durch die beschriebene Trennschicht also eine Art Sollbruchstelle in der Baugruppe geschaffen, welche auf einfache Weise eine kontrollierte und automatisierbare Auftrennung in die Teilelemente ermöglicht. Diese Auftrennung erleichtert die Abtrennung von bestimmten Arten solcher Teilelemente aus einer größeren Menge von Elektroschrott, was wiederum die Rückgewinnung von wertvollen oder auch schädlichen Rohstoffen aus diesen Teilelementen erleichtert. Durch die mit der Erfindung ermöglichte leichte Auftrennung können entweder die beschriebenen Teilelemente oder auch weitere darin enthaltene Teilkomponenten leichter dem Recycling zugeführt werden. Die hier beschriebene Auftrennung ist also als unterstützender Teilschritt in einem übergeordneten Recycling-Verfahren zu verstehen. Bei dem übergeordneten Recycling-Verfahren können dann insbesondere die in der Baugruppe enthaltenen Metalle, Schadstoffe, aber auch keramische Materialien und/oder Kunststoffe sowie andere wertvolle oder potentiell schädlich Materialien aus der Gesamtmasse des Elektroschrotts abgetrennt werden und entweder als Rohstoffe erneut Verwendung finden oder zumindest einer separaten, umweltgerechten Entsorgung zugeführt werden. Damit kann die Erfindung einen Beitrag leisten, Recycling-Prozesse für Elektronik-Baugruppen auf breiterer Basis umzusetzen und die Wiederverwendung von Rohstoffen bzw. eine sichere Entsorgung von Gefahrstoffen zu fördern.

Das erfindungsgemäße Verfahren ist entsprechend ein Verfahren zum Recyceln von wenigstens einer Teilkomponente einer solchen erfindungsgemäßen Elektronik-Baugruppe. Das Verfahren umfasst einen Trennschritt, bei dem die Elektronik-Baugruppe durch eine Auftrennung im Bereich der Trennschicht mittels Zünden einer exothermen chemischen Reaktion innerhalb der Reaktionsschicht in das erste Teilelement und das zweite Teilelement zerlegt wird. Dabei kann die zu recycelnde Teilkomponente entweder eines der beschriebenen Teilelemente selbst sein, in die die Baugruppe in dem Trennschritt zerlegt wird, oder aber die Teilkomponenten ist eine weitere Unterkomponente des ersten oder zweiten Teilelements, z.B. eine Unterkomponente mit einem besonders wertvollen Rohstoff oder einem besonders gefährlichen Schadstoff. Auf diese Weise kann die Teilkomponente von der Hauptmenge des Elektroschrotts abgetrennt werden und leichter recycelt werden. Insgesamt entsprechen die Vorteile des erfindungsgemäßen Verfahrens den bereits beschriebenen Vorteilen der erfindungsgemäßen Elektronik-Baugruppe.

Vorteilhafte Ausgestaltungen und Weiterbildungen der Erfindung gehen aus den von Anspruch 1 abhängigen Ansprüchen sowie der folgenden Beschreibung hervor. Dabei können die beschriebenen Ausgestaltungen des Elektronik-Baugruppe und des Recycling-Verfahrens allgemein vorteilhaft miteinander kombiniert werden.

So kann die Reaktionsschicht in der Elektronik-Baugruppe allgemein vorteilhaft dazu ausgelegt sein, durch einen optischen Zündpuls, einen elektrischen Zündpuls und/oder einen thermischen Zündpuls gezündet zu werden. Alternativ oder zusätzlich kann sie auch dazu ausgelegt sein, mittels chemischer bzw. elektrochemischer Zündung und/oder mittels einer Zündung durch Kompression, also durch Druck, gezündet zu werden. Alle beschriebenen Varianten ermöglichen es auf einfache Weise, innerhalb eines Recycling-Verfahrens eine maschinelle und insbesondere auch automatisierbare Auslösung des Trennschritts durchzuführen. Beispielsweise kann ein elektrischer Zündpuls durch ein kurzfristiges Anlegen einer ausreichend hohen elektrischen Spannung in einem Teilbereich der Baugruppe erreicht werden. Ein optischer und/oder thermischer Zündpuls kann beispielsweise durch kurzfristiges Einwirken eines Lasers in einem Teilbereich des Bauteils erreicht werden. Von dem Teilbereich der Reaktionsschicht aus, in dem der Zündpuls aufgenommen wird, kann sich die chemische Reaktion dann auf die beschriebene Weise selbständig fortpflanzen. Dadurch ist keine besonders präzise Steuerung der Zündung erforderlich, sondern es muss nur eine gegebene Zündschwelle überschritten werden (beispielsweise in Form einer Temperatur- oder Spannungsschwelle oder einer Leistungsschwelle eines optischen Pulses). Hierdurch wird die automatisch getriggerte Zündung auch in einer größeren Ansammlung von derartigen Baugruppen erleichtert.

Um eine solche Zündung zu erleichtern, kann die Elektronik-Baugruppe zwischen einer Außenfläche der Baugruppe und der Reaktionsschicht ein zündpulsleitendes und insbesondere ein lichtleitendes Element umfassen. Ein solches lichtleitendes Element kann einen im Bereich der Außenfläche einwirkenden optischen Zündpuls (z.B. einen Laserpuls) in den zu zündenden Bereich der Reaktionsschicht weiterleiten. So kann das lichtleitende Element zum Beispiel eine Glasfaser oder eine andere lichtleitende Faser sein. Alternativ kann zwischen der Außenfläche der Baugruppe und der Reaktionsschicht ein thermisch leitfähiges Element und/oder eine elektrische Leitung vorliegen, um ihn ähnlicher Weise einen thermischen oder elektrischen Zündpuls in den Bereich der Reaktionsschicht weiterzuleiten. Dabei kann es sich insbesondere um eine metallische Zuleitung handeln. Alternativ kann aber auch eine keramische Zuleitung und/oder eine Zuleitung mit einer Diamantschicht vorgesehen sein, um einen thermischen Puls in den Bereich der Reaktionsschicht einkoppeln zu können. Den beschriebenen pulsweiterleitenden Elementen ist gemeinsam, dass sie alle die Weiterleitung eines relativ unspezifisch im Außenbereich einwirkenden Zündpulses an die richtige Stelle, also in den Bereich der Reaktionsschicht, ermöglichen. So kann ein im Außenbereich der Baugruppe einwirkender Zündpuls "eingefangen" werden, und es ist insbesondere keine besonders ortsgenaue Fokussierung des Zündpulses an die richtige Stelle erforderlich.

Allgemein vorteilhaft und unabhängig von dem tatsächlich eingesetzten Zündmechanismus kann die Reaktionsschicht temperaturstabil bei einer Temperatur von wenigstens 200 °C und insbesondere sogar temperaturstabil bei einer Temperatur von wenigstens 500 °C ausgebildet sein. Mit anderen Worten liegt die Auslösetemperatur für ein thermisches Zünden der Reaktionsschicht so hoch, dass die Baugruppe bei einer Temperatur von wenigstens 200 °C und insbesondere sogar wenigstens 500°C betrieben werden kann, ohne dass in diesem Bereich schon eine (ungewollte) Zündung stattfindet. So kann verhindert werden, dass schon bei einer Erwärmung während des normalen Betriebs oder auch während der Herstellung eine unerwünschte Zündung auftritt. Vielmehr soll die Zündung der Reaktionsschicht erst bei einem wesentlich stärkeren thermischen Zündpuls (alternativ auch elektrisch oder optisch oder auf eine der anderen oben erwähnten Arten) in kontrollierter Weise als Teilschritt des Recycling-Prozesses ausgelöst werden. Diese vergleichsweise hohe Zündschwelle kann einerseits durch die Materialzusammensetzung der Reaktionsschicht und andererseits auch durch die Granularität ihrer Struktur eingestellt werden. In jedem Fall soll die Aktivierungsschwelle der exothermen chemischen Reaktion ausreichend hoch sein, dass eine Erwärmung in den genannten Bereich ohne eine verfrühte Zündung möglich ist.

Gemäß einer vorteilhaften Ausführungsform kann durch die Zündung der exothermen chemischen Reaktion eine Reaktionstemperatur ausgebildet werden, die im Bereich zwischen 500 °C und 4000 °C und insbesondere zwischen 1000 °C und 2000 °C liegt. Derart hohe Reaktionstemperaturen können mit heutzutage verfügbaren reaktiven Schichtsystemen in der räumlich begrenzten Umgebung der Reaktionsschicht leicht erreicht werden. Mit derart hohen Reaktionstemperaturen kann insbesondere eine schnelle thermisch induzierte Auftrennung einer stoffschlüssigen Verbindung in der Elektronik-Baugruppe bewirkt werden.

Gemäß einer allgemein vorteilhaften Ausführungsform der Reaktionsschicht kann diese Aluminium, Nickel, Titan, Zirconium, Silizium und/oder Palladium umfasst. Die Reaktionsschicht kann insbesondere wenigstens zwei Materialkomponenten aus dieser Liste umfassen, beispielsweise ein Gemisch aus Aluminium und Nickel, aus dem durch eine stark exotherme Reaktion Nickelaluminid gebildet wird. In ähnlicher Weise kann ein Gemisch aus Titan und Aluminium vorliegen, aus dem Titanaluminid gebildet werden kann, oder es kann ein Gemisch aus Zirconium und Aluminium vorliegen, aus dem Zirconiumaluminid gebildet werden kann, oder es kann ein Gemisch aus Palladium und Aluminium vorliegen, aus dem Palladiumaluminid gebildet werden kann. Alternativ kann auch beispielsweise ein Gemisch aus Titan und Nickel vorliegen, aus dem eine intermetallische Titan-Nickel-Verbindung gebildet werden kann oder es kann ein Gemisch aus Titan und Silizium vorliegen, aus dem ein Titansilizid gebildet werden kann, oder es kann ein Gemisch aus Zirconium und Silizium vorliegen, aus dem ein Zirconiumsilizid gebildet werden kann. Diese Materialgemische sind nur beispielhaft zu verstehen, und es sind noch zahlreiche weitere Materialsysteme bekannt, die hier vorteilhaft zum Einsatz kommen können, da sie in geeigneter Weise durch eine Zündung zur exothermen Reaktion gebracht werden können. Dies kann insbesondere auch ein Einkomponenten-Material sein, oder es können zusätzlich zu den genannten Gemischen mit jeweils zwei Komponenten auch noch ein oder weitere Materialkomponenten hinzukommen.

Allgemein und unabhängig von der genauen Materialzusammensetzung der Reaktionsschicht ist es vorteilhaft, wenn diese bereits im unreagierten Zustand elektrisch leitfähige und/oder thermisch gut leitende Eigenschaften aufweist. Dies bewirkt, dass in der Elektronik-Baugruppe bei ihrem Betrieb eine thermische und/oder elektrische Anbindung der beiden Teilelemente über die Reaktionsschicht hinweg erreicht werden kann. Oder, anders ausgedrückt, wird ein thermischer und/oder elektrischer Pfad, der im Verbindungsbereich gebildet ist, durch die zumindest lokal vorhandene Reaktionsschicht nicht unterbrochen. Dieser Vorteil wird mit den vorab beschriebenen Materialsystem erreicht, welche wenigstens eine und insbesondere sogar zwei metallische Materialkomponenten aufweisen.

Gemäß einer weiteren allgemein vorteilhaften Ausführungsform der Reaktionsschicht ist diese als reaktives Multischichtsystem und insbesondere als reaktive Multischichtfolie ausgebildet. Hierbei umfasst die Reaktionsschicht vorteilhaft wenigstens zwei Materialkomponenten, wobei die einzelnen Teilschichten der Multischichtfolie aus wenigstens zwei unterschiedlichen Materialien gebildet sind. Dabei liegen die unterschiedlichen Materialien in jeweils miteinander abwechselnden Teilschichten des Schichtstapels vor. Die unterschiedlichen Materialien der Teilschichten bilden insbesondere verschiedene Reagenzien (also Edukte) für die exotherme chemische Reaktion. Die einzelnen Teilschichten der Multischichtfolie sind dabei insbesondere vergleichsweise dünn ausgebildet, sodass sich ein geringer räumlicher Abstand der an der exothermen Reaktion beteiligten Edukte ergibt. Dieser geringe räumliche Abstand erleichtert sowohl das Zünden als auch das Fortpflanzen der exothermen Reaktion.

Besonders vorteilhaft kann es sich bei der reaktiven Multischichtfolie um eine nanostrukturierte Multischichtfolie handeln. Mit anderen Worten kann die Dicke der einzelnen Teilschichten des Schichtsystems jeweils unterhalb von 1 µm liegen. Die Gesamtdicke der Multischichtfolie kann beispielsweise in einem Bereich zwischen 10 µm und 300 µm liegen. Eine derart gewählte Foliendicke ist geeignet, um eine für die thermisch induzierte Auftrennung der Baugruppe ausreichende Energiemenge bereitzustellen. Andererseits ist die Reaktionsschicht trotzdem dünn genug, um den Eingriff in die Gesamtkonstruktion der Baugruppe und damit den Einfluss auf die Größe sowie thermische und elektrische Eigenschaften und auch das Risiko einer ungewollten Zündung relativ gering zu halten.

Gemäß einer alternativen vorteilhaften Ausführungsform kann das Edukt-Material bzw. die Mehrzahl von Materialkomponenten aber auch in Form von Mikropartikeln in der Reaktionsschicht vorliegen. Insbesondere bei Vorliegen von zwei oder mehr Materialkomponenten kann es sich beispielsweise um Partikel mit lamellarer Struktur handeln. Dabei sind die einzelnen Partikel aus mehreren Schichten der einzelnen Materialkomponenten zusammengesetzt, wobei die Teilschichten innerhalb der Partikel eine Lamellenstruktur ausbilden. Es kann sich also beispielsweise um flockenartige Multischicht-Partikel handeln. Alternativ können die Mikropartikel aber auch als Kern-Hülle-Partikel vorliegen, bei denen die erste Materialkomponenten einen innenliegenden Kern ausbildet und die zweite Materialkomponente eine daran angrenzende Umhüllung ausbildet. Schließlich kann gemäß einer weiteren Alternative ein Gemisch aus zwei oder mehr Partikelsorten vorliegen, bei denen jeweils eine Materialkomponenten eine Partikelsorte des Gemischs ausbildet. Unabhängig von der genauen Ausführungsform für die Zusammensetzung und den Aufbau der einzelnen Partikel können diese jeweils insgesamt pulverartig ausgebildet sein. Auch ein solches reaktives Pulversystem aus ein oder mehreren Edukt-Materialien eignet sich gut, um eine exotherme Reaktion an einer Stelle zu zünden, die sich dann anschließend von allein über die restlichen Bereiche der Schicht fortpflanzen kann. Dabei kann das Pulver der Edukt-Materialien optional in ein zusätzliches Matrixmaterial eingebunden sein, beispielsweise in einen Kunststoff, insbesondere ein Polymer, oder in ein metallisches Schmelzmaterial wie z.B. ein zinnhaltiges Lotmaterial. Alternativ kann das Pulver der Edukt-Materialien aber auch ohne ein zusätzliches Matrix-Material zu einem festen Verbund verpresst sein.

Gemäß einer weiteren allgemein vorteilhaften Ausführungsform kann die Trennschicht zusätzlich zu der Reaktionsschicht noch eine weitere Schicht umfassen. Diese weitere Schicht kann insbesondere eine Kopplungsschicht sein, die eine stoffschlüssige Verbindung zwischen den beiden Teilelementen vermittelt, wobei diese stoffschlüssige Verbindung durch die Erhitzung beim Zünden der exothermen Reaktion in der Reaktionsschicht wieder gelöst wird. So kann es sich beispielsweise bei der weiteren Schicht um eine Lotschicht oder eine Kopplungsschicht aus einem Polymer, insbesondere um eine Klebeschicht, handeln. Die Lotschicht bzw. die Polymerschicht kann dann durch die exotherme Reaktion zum Schmelzen, Reißen und/oder Veraschen gebracht werden, so dass die durch sie vermittelte stoffschlüssige Verbindung gelöst wird. Es handelt sich also bei der weiteren Schicht insbesondere um eine Opferschicht, die als Folge der exothermen Reaktion weitgehend zerstört wird. Dies wird besonders vorteilhaft dadurch erreicht, dass diese weitere Schicht direkt benachbart zur Reaktionsschicht angeordnet ist. Wenn es sich bei der weiteren Schicht um eine Polymerschicht handelt, ist ein Duroplast als Material der Polymerschicht besonders bevorzugt, da ein solches Material an der Oberfläche verascht und es bei der Abkühlung nach der exothermen Reaktion (im Gegensatz zu einem Thermoplasten) nicht zu einer erneuten Verbindung der Teilelemente kommt.

Alternativ zu der beschriebenen Ausführungsform mit einer weiteren Schicht als Opferschicht kann jedoch die Trennung in die beiden Teilelemente auch dadurch erfolgen, dass durch die Hitze der exothermen Reaktion ein mechanisches Aufreißen bzw. eine Delamination im Verbindungsbereich bewirkt wird, ohne dass hier eine zusätzliche Opferschicht angeordnet wäre.

Gemäß einer ersten vorteilhaften Ausführungsform für die Geometrie des Verbindungsbereichs kann dieser ein vollflächiger Verbindungsbereich zwischen den beiden Teilelementen sein. Mit anderen Worten kann der Verbindungsbereich dabei so groß sein wie eine der Hauptflächen des ersten und/oder zweiten Teilelements und insbesondere einen überwiegenden Teil der Hauptflächen beider Teilelemente abdecken. Es handelt sich also um eine vollflächige Berührungsfläche zwischen zwei flächigen Teilelementen. Diese Ausführungsform liegt zum Beispiel dann vor, wenn mehrere Schichten eines Schaltungsträgers flächig miteinander verbunden sind. Die beiden Teilelemente können dabei eine weitgehend übereinstimmende Grundfläche aufweisen, welche dann auch der Größe des Verbindungsbereichs entspricht. Durch die Merkmale der vorliegenden Erfindung kann dann eine einfache Auftrennung dieser vollflächigen Verbindung ermöglicht werden.

Gemäß einer alternativen Ausführungsform kann der Verbindungsbereich aber auch nur einen lokalen Teilbereich einer Hauptfläche des ersten Teilelements ausbilden. So kann zum Beispiel das erste Teilelement ein großflächiger Schaltungsträger sein, auf dem eine Mehrzahl von diskreten zweiten Teilelementen in Form von einzelnen Bauelementen, aufgebracht ist. Bei den Verbindungsbereichen zu diesen diskreten Bauelementen handelt es sich dann entsprechend um lokal begrenzte Teilbereiche der Oberfläche des Schaltungsträgers.

Allgemein und unabhängig davon, ob der Verbindungsbereich vollflächig oder lokal ausgebildet ist, kann der Verbindungsbereich nur in einzelnen lokalen Teilbereichen die beschriebene Reaktionsschicht aufweisen. Bei dieser Ausführungsform ist also der Verbindungsbereich nur punktuell von der Reaktionsschicht durchsetzt, so dass diese eine Art Perforation bzw. ein Netz von Sollbruchstellen ausbildet. Auch bei dieser Variante kann das Zünden der exothermen Reaktion zu einer Fortpflanzung der Reaktion über den ganzen Verbindungsbereich hinweg führen, und als Folge dieser exothermen Reaktion kann über den ganzen Verbindungsbereich hinweg aufreißen. Dies wird dadurch ermöglicht, dass auch in den Zwischenbereichen, in denen keine Reaktionsschicht vorgesehen ist, eine hohe thermische und mechanische Belastung auftritt, die hier ebenfalls zu einem Aufreißen der Verbindung führt. Diese Ausgestaltungsvariante mit einer nur punktuell vorhandenen Reaktionsschicht geht mit einem geringeren Materialverbrauch für das Material der Reaktionsschicht einher, und der Einfluss auf den Gesamtaufbau der Elektronik-Baugruppe ist entsprechend verringert.

Alternativ kann die Reaktionsschicht aber auch jeweils den ganzen Verbindungsbereich abdecken. Auch dies gilt unabhängig davon, ob der Verbindungsbereich selbst vollflächig oder nur lokal ausgebildet ist.

Das erste Teilelement kann allgemein vorteilhaft ein Schaltungsträger der Baugruppe sein. Es kann sich also z.B. um eine Leiterplatte oder auch um einen keramischen Schaltungsträger handeln. In jedem Fall kann dieser Schaltungsträger die mechanische und/oder elektrische Basis der Baugruppe bilden, von der die weiteren Elemente getragen werden. Aufgrund der erfindungsgemäßen Ausgestaltung können die weiteren Bauelemente oder auch ein oder mehrere weitere großflächige Schaltungsträger (oder Teilschichten davon) mit dem Basiselement verbunden sein, wobei trotzdem eine einfache Trennung im Zuge des Recycling-Prozesses ermöglicht ist.

Bei dem zweiten Teilelement kann es sich insbesondere um ein elektronisches Bauelement und/oder einen Kühlkörper und/oder ein Gehäuseelement und/oder ein weiteres tragendes Element handeln. Dieses zweite Teilelement kann insbesondere über den beschriebenen Verbindungsbereich mit dem Schaltungsträger verbunden sein. Es kann auch eine Vielzahl solcher zweiter Teilelemente vorgesehen sein, die auch untereinander unterschiedlich ausgestaltet sein können, bzw. es können weitere (dritte, vierte, etc.) solche Teilelemente vorliegen und ggf. mit dem ersten Teilelement oder auch untereinander verbunden sein. Diese zweiten und ggf. weiteren Teilelemente können insbesondere ein oder mehrere (edel-)metallische Komponenten und/oder Schadstoffe und/oder Polymere umfassen, die im Rahmen eines Recycling-Prozesses von dem Haupt-Schaltungsträger getrennt werden sollen. So kann eine Wiederverwendung von wertvollen Ressourcen und/oder eine sichere Entsorgung von Schadstoffen auf vereinfachte Weise ermöglicht werden.

Nachfolgend wird die Erfindung anhand einiger bevorzugter Ausführungsbeispiele unter Bezugnahme auf die angehängten Zeichnungen beschrieben, in denen:
- Figur 1: eine schematische Schnittdarstellung einer Elektronik-Baugruppe während des Recycling-Verfahrens nach einem ersten Beispiel der Erfindung zeigt,
- Figur 2: eine vereinfachte Darstellung eines Verbindungsbereichs zeigt mit verschiedenen Varianten für die Art der Trennung,
- Figuren 3 bis 5: eine Elektronik-Baugruppe mit mehreren Teilelementen und deren Auftrennung beim Recycling zeigen und
- Figuren 6 bis 8: mehrere Beispiele für lokal ausgebildete Verbindungsbereiche in Elektronik-Baugruppen zeigen.

In den Figuren sind gleiche oder funktionsgleiche Elemente mit gleichen Bezugszeichen versehen.

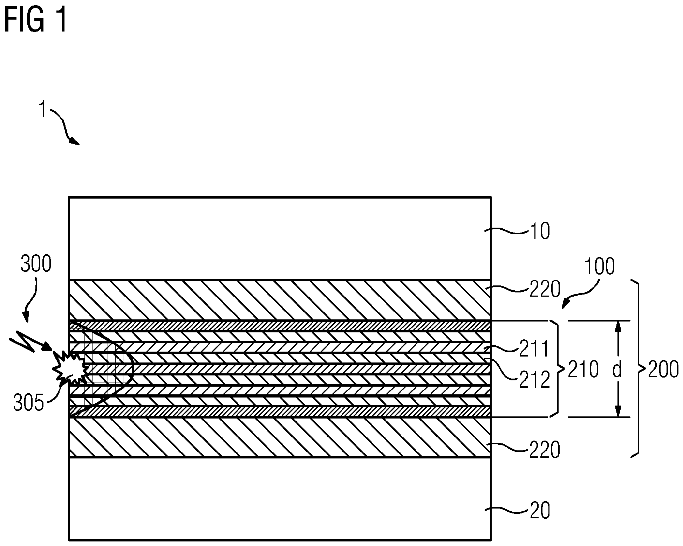

So zeigt Figur 1 eine schematische Querschnittsdarstellung für einen Ausschnitt aus einer Elektronik-Baugruppe 1 nach einem ersten Beispiel der Erfindung. Diese Baugruppe 1 umfasst zwei Teilelemente 10 und 20, die in einem Verbindungsbereich 100 flächig miteinander verbunden sind. Beispielsweise können zwei Teilschichten 10 und 20 einer Platine in dem Verbindungsbereich 100 zu einem übergeordneten Schaltungsträger zusammengesetzt sein. Der Verbindungsbereich kann vollflächig sein, also den wesentlichen Teil der Grundfläche der beiden Teilelemente 10 und 20 abdecken. Er kann aber auch nur lokal ausgebildet sein, z.B. wenn ein einzelnes Bauelement 20 nur in einem lokalen Abschnitt eines Schaltungsträgers 10 angeordnet ist. In einem solchen Fall würde Figur 1 nur einen lokalen Ausschnitt im Bereich des diskreten Bauelements 20 darstellen.

In jedem Fall umfasst der Verbindungsbereich 100 eine Trennschicht 200. Zunächst sind die beiden Teilelemente 10 und 20 über diese Trennschicht miteinander verbunden. Es handelt sich um eine dauerhafte Verbindung, die während des normalen Betriebs der Baugruppe 1 aufrechterhalten bleibt. Im Rahmen eines Recycling-Verfahrens kann die Baugruppe jedoch mittels der Trennschicht 200 in die einzelnen Teilelemente 10 und 20 aufgetrennt werden. Hierzu umfasst die Trennschicht 200 eine Reaktionsschicht 210, in der eine exotherme chemische Reaktion gezündet werden kann. Im gezeigten Beispiel handelt es sich bei der Reaktionsschicht 210 um eine reaktive Multischichtfolie, welche aus miteinander abwechselnden Teilschichten 211 und 212 gebildet ist. Dabei kann insbesondere in den ersten Teilschichten 211 ein erstes Edukt-Material vorliegen, und in den zweiten Teilschichten 212 kann ein zweites Edukt-Material vorliegen. Diese beiden Materialkomponenten können nach einer Zündung durch einen Zündpuls 300 exotherm miteinander reagieren. Die gezeigten Teilschichten können für eine wesentlich höhere Anzahl von miteinander abwechselnden Teilschichten stehen, welche insbesondere Einzel-Schichtdicken im Sub-Mikrometerbereich aufweisen können. Beispielsweise kann es sich bei dem ersten Edukt-Material um Nickel und bei dem zweiten Edukt-Material um Aluminium handeln. Bei der exothermen chemischen Reaktion dieser beiden Materialien wird Nickelaluminid gebildet und gleichzeitig thermische Energie freigesetzt.

Die Zündung der exothermen chemischen Reaktion in der Reaktionsschicht 210 wird durch einen in der Figur 1 schematisch dargestellten Zündpuls 300 ausgelöst. Dabei kann es sich beispielsweise um einen elektrischen, optischen und/oder thermischen Puls handeln. In dem Teilbereich der Reaktionsschicht, in dem der Zündpuls 300 einwirkt, wird die Aktivierungsenergie der exothermen Reaktion überschritten und die beiden Edukt-Materialien der unterschiedlichen Teilschichten können miteinander reagieren. Durch die hierbei freigesetzte Reaktionswärme pflanzt sich der Reaktionsbereich 305 der exothermen Reaktion lateral durch die Schicht hindurch fort. Dies geschieht mit einer vergleichsweise hohen Geschwindigkeit, wobei an einem gegebenen Ort der Folie die hohe Reaktionstemperatur nur für sehr kurze Zeit vorliegt. Die Gesamtdicke der Reaktionsschicht ist mit dem Bezugszeichen d gekennzeichnet. Sie kann beispielsweise
einige 10 µm betragen.

Beim Beispiel der Figur 1 weist die Trennschicht 200 zusätzlich zu der Reaktionsschicht noch zwei weitere Schichten 220 auf, welche beidseitig der Reaktionsschicht angeordnet sind und jeweils eine stoffschlüssige Kopplung zu dem angrenzenden Teilelement 10 bzw. 20 vermitteln. Diese weiteren Schichten sind jedoch grundsätzlich optional, und die Kopplung der beiden Teilelemente kann insbesondere auch durch die Reaktionsschicht 210 selbst vermittelt sein. Wenn jedoch ein oder mehrere solche Kopplungsschichten 220 vorliegen, kann es sich dabei beispielsweise um Lotschichten und/oder Kleberschichten handeln. Durch das Zünden der exothermen Reaktion in der Reaktionsschicht 210 kann die jeweilige Kopplungsschicht 220 so weit beschädigt oder zerstört werden, dass die stoffschlüssige Kopplung der beiden Teilelemente 10 und 20 aufgehoben wird und die Baugruppe in die Teilelemente aufgetrennt wird. Hierzu kann die Zündung der exothermen Reaktion gezielt im Rahmen eines Trennschritts während eines Recycling-Prozesses erfolgen. Auch wenn keine zusätzliche Kopplungsschicht 220 vorliegt und die stoffschlüssige Kopplung der beiden Teilelemente z.B. direkt durch die Reaktionsschicht 210 vermittelt wird, bewirkt die Zündung der exothermen Reaktion eine Trennung der Verbindung, z.B. durch thermische Rissbildung und/oder eine verringerte Haftung.

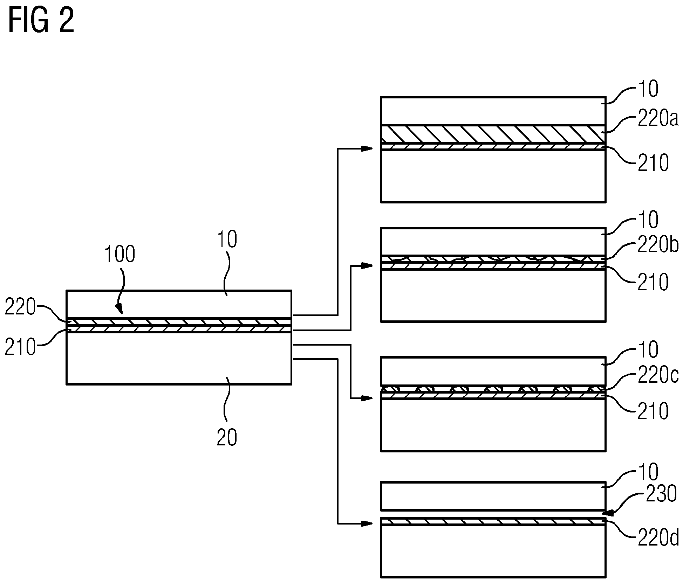

In Figur 2 ist eine vereinfachte Darstellung eines Verbindungsbereichs 100 in einer ähnlichen Baugruppe mit zwei Teilelementen 10 und 20 gezeigt, zusammen mit verschiedenen Varianten für die Art der beim Zünden bewirkten Auftrennung. Beim Beispiel der Figur 2 liegt zwischen den beiden Teilelementen 10 und 20 wiederum eine Reaktionsschicht 210 vor, welche beispielsweise ähnlich wie in Figur 1 aufgebaut sein kann. Alternativ kann die Reaktionsschicht statt mit einer Multischichtfolie aber auch mit einem Pulver aus Partikeln der jeweiligen Edukte gebildet sein. Beim Beispiel der Figur 2 ist nur auf einer Seite, nämlich oberhalb der Reaktionsschicht 210 eine weitere Kopplungsschicht 220 angeordnet. Im rechten Teil der Figur 2 sind verschiedene Beispiele dafür gezeigt, wie sich diese Kopplungsschicht 220 aufgrund der in der Reaktionsschicht 210 gezündeten exothermen Reaktion verändern kann: So kann gemäß der obersten Skizze nach der Reaktion eine Kopplungsschicht 220a mit stark vergrößertem Volumen vorliegen, wodurch die Trennung in die Teilelemente 10, 20 wesentlich erleichtert wird. Alternativ kann die Reaktion zu einer Rissbildung in der Kopplungsschicht führen, entsprechend dem Bezugszeichen 220b. Alternativ kann die Reaktion zu einer geschmolzenen und/oder veraschten Kopplungsschicht führen, was durch die mit dem Bezugszeichen 220c gekennzeichneten Reste angedeutet ist. Oder die Reaktion kann zu einer verringerten Haftung zwischen dem angrenzenden Teilelement und der thermisch veränderten Kopplungsschicht 220d führen. Dies ist durch die neu entstandene Lücke 230 angedeutet. Analog zur Ausbildung dieser Lücke 230 in der untersten Teilskizze können auch die anderen Veränderungen der Kopplungsschicht zu einer entsprechenden Lückenbildung und Auftrennung in die Teilelemente führen. Und auch bei einer direkten Anbindung der Reaktionsschicht 210 an die Teilelemente (ohne die hier gezeigte optionale Kopplungsschicht) kann es zu einer ähnlichen Verringerung der Haftung aufgrund der exothermen Reaktion kommen. In jedem Fall führt die Reaktionswärme der Reaktion direkt oder indirekt zu einer Auftrennung der Baugruppe in die Teilelemente, ausgelöst durch eine kontrollierte Zündung während des Recycling-Prozesses.

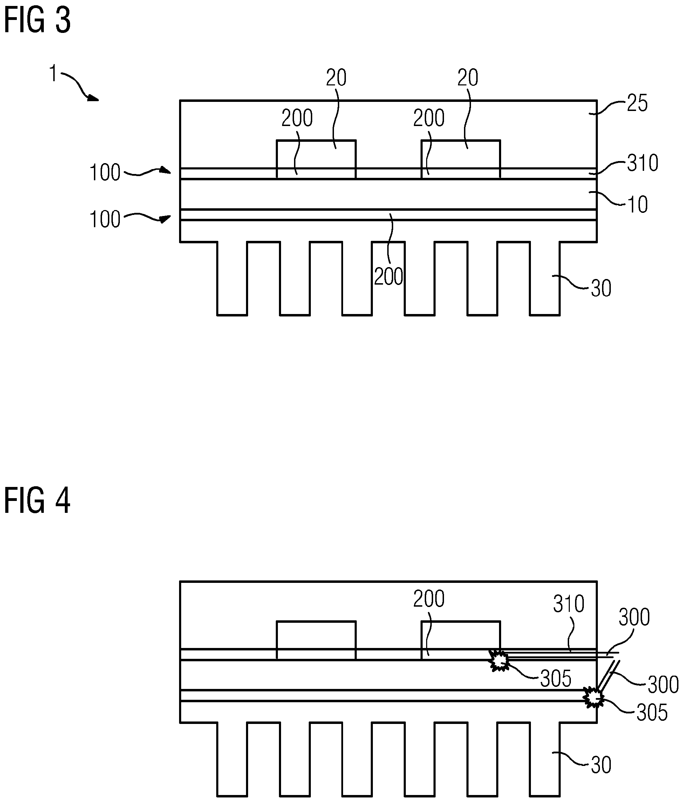

Figur 3 zeigt eine Elektronik-Baugruppe 1 nach einem weiteren Beispiel der Erfindung. Diese Baugruppe umfasst ein erstes Teilelement 10, das hier den zentralen Schaltungsträger darstellt. Dies kann beispielsweise eine Platine sein. Auf der Oberseite dieses Schaltungsträgers sind zwei diskrete elektronische Bauelemente 20 aufgebracht, wobei sich zwischen dem Schaltungsträger 10 und dem jeweiligen Bauelement 20 ein zugehöriger lokaler Verbindungbereich 100 befindet. In diesem Verbindungsbereich ist lokal eine Trennschicht 200 ausgebildet. Diese Trennschicht umfasst eine Reaktionsschicht, in der eine exotherme Reaktion gezündet werden kann. Um einen weiter außen angelegten Zündpuls in den Bereich dieser Reaktionsschicht weiterleiten zu können, ist zwischen den Teilelementen 10 und 20 zusätzlich eine lichtleitende Glasfaser 310 angeordnet. Auf ihrer Außenseite sind die beiden Bauelemente 20 von einem Vergussmittel 25 umgeben, das die Bauelemente umhüllt und vor Umgebungseinflüssen schützt. Auf seiner Unterseite ist der Schaltungsträger 10 flächig mit einem weiteren Teilelement 30, nämlich hier mit einem Kühlkörper verbunden. Der dort ausgebildete Verbindungsbereich 100 ist vollflächig mit einer entsprechenden Trennschicht 200 versehen, die auch hier eine Reaktionsschicht enthält, deren exotherme Reaktion zur Trennung in die Teilelemente 10 und 30 führt.

In Figur 4 ist diese Elektronik-Baugruppe in einem Stadium am Ende ihrer Betriebslebensdauer gezeigt, bei dem sie innerhalb eines Recycling-Verfahrens in ihre einzelnen Teilelemente 10, 20, 30 zerlegt werden soll. Hierzu wird im Randbereich der beiden Verbindungsbereiche 100 ein Zündpuls 300 eingekoppelt. Es kann sich beispielsweis um einen optischen Zündpuls handeln, der mit einem Laser in diese Randbereiche eingekoppelt wird. Im unteren Verbindungsbereich zwischen den Teilelementen 10 und 30 ragt die Reaktionsschicht in der Trennschicht 200 bis in den Randbereich, so dass der Zündpuls hier direkt in die Reaktionsschicht eingekoppelt werden kann und dort einen selbständig weiterpropagierenden Reaktionsbereich 305 ausbildet, ähnlich wie beim Beispiel der Figur 1. Im oberen Verbindungsbereich zwischen den Teilelementen 10 und 20 liegt dagegen die Reaktionsschicht weiter innen. Um den Zündpuls 300 trotzdem in diesen Bereich einzukoppeln, wird der Laserpuls aus dem Randbereich über die lichtleitende Glasfaser in den Bereich der Trennschicht 200 weitergeleitet, so dass sich auch hier ein Reaktionsbereich 305 ausbilden kann.

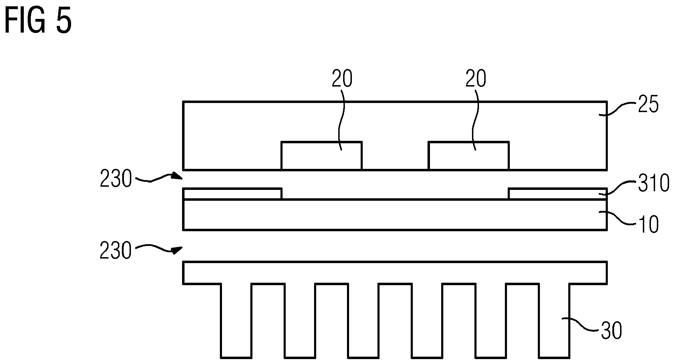

In Figur 5 ist schließlich diese Baugruppe nach dem Ablauf der exothermen Reaktion in den jeweiligen Trennschichten 200 gezeigt. Wie durch die entsprechenden Lücken 230 angedeutet, ist die Baugruppe jetzt in den Schaltungsträger 10, die beiden noch mit dem Vergussmittel 25 verbundenen Bauelemente 20 und den Kühlkörper 30 zerlegt. Die Trennschichten 200 sind dabei weitgehend verascht worden oder zerschmolzen oder auf andere Weise desintegriert - es können aber auch noch hier nicht dargestellte Reste der Trennschicht an den einzelnen Teilelementen übrig geblieben sein. Wesentlich ist, dass durch die Zündung der exothermen Reaktion eine durch die Trennschichten 200 vermittelte Kopplung soweit zerstört oder reduziert wird, dass aufgrund der im Verbindungsbereich freigesetzten Reaktionswärme eine Trennung in die Teilelemente 10, 20 und 30 erfolgt.

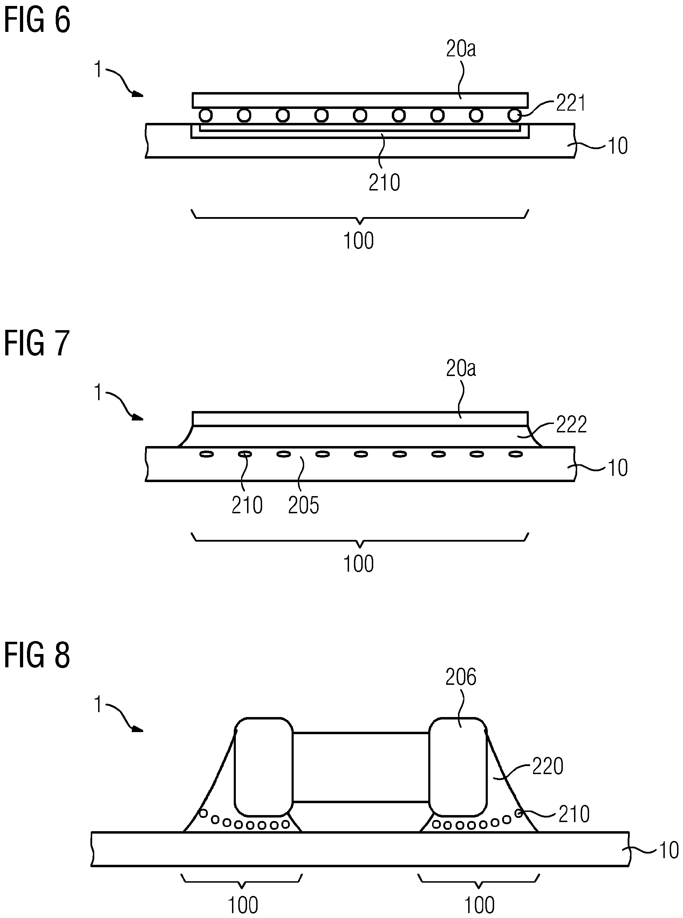

Figur 6 zeigt ein weiteres Beispiel für einen Ausschnitt aus einer elektronischen Baugruppe 1, in der ein lokaler Verbindungsbereich 100 zwischen einem (größerflächigen) Schaltungsträger 10 und einem Bauelement ausgebildet ist. Das Bauelement ist hier ein Halbleiterchip 20a. Dieser Halbleiterchip 20a ist über eine Mehrzahl von Bond Bumps 221 mit dem darunterliegenden Schaltungsträger 10 verbunden. Unterhalb der Bond Bumps 221 liegt eine in den Schaltungsträger 10 eingebettete Trennschicht vor, welche eine Reaktionsschicht 210 umfasst und in diesem Beispiel auch im Wesentlichen durch diese Reaktionsschicht gebildet ist. Diese Reaktionsschicht erstreckt sich hier vollflächig über die Grundfläche des Halbleiterchips 20a. Wenn innerhalb eines Recycling-Prozesses die exotherme Reaktion in dieser Schicht 210 gezündet wird (gegebenenfalls über ein optional vorhandenes pulsleitendes Element), dann kommt es aufgrund der Reaktionswärme zu einem Aufschmelzen der Bond Bumps oder zu einem Ablösen eines Teilbereichs des Substrats unterhalb des Halbleiterchips 20a und damit zu einer Auftrennung der Verbindung zwischen Schaltungsträger 10 und Halbleiterchip 20a.

Figur 7 zeigt ein weiteres Beispiel für einen Ausschnitt aus einer elektronischen Baugruppe 1, in der ebenfalls ein Halbleiterchip 20a auf einem größerflächigen Schaltungsträger 10 aufgebracht ist. Im Unterschied zum vorhergehenden Beispiel ist hier der Bereich zwischen Halbleiterchip 20a und Schaltungsträger mit einem sogenannten Underfill 222 unterfüllt. Auch hier ist im Verbindungsbereich 100 eine Reaktionsschicht 210 in den Schaltungsträger 10 eingebettet. Im Unterschied zum vorhergehenden Beispiel liegt diese Reaktionsschicht jedoch nicht vollflächig im ganzen Verbindungsbereich vor, sondern nur punktuell, sozusagen im Bereich kleiner Inseln. Zwischen diesen Inseln sind Zwischenbereiche 205 vorhanden, in denen jeweils keine Reaktionsschicht vorliegt. Diese Zwischenbereiche 205 sind jedoch insbesondere schmal genug, dass nach der Zündung der exothermen Reaktion in einem Teilbereich der Reaktionsschicht eine Propagation dieser Reaktion auch zu den benachbarten Inseln und damit über den ganzen Verbindungsbereich erfolgt. Alternativ können die Inseln aber auch deutlicher voneinander separiert sein, und die Zündung kann durch eine allgemeine Erwärmung der Baugruppe erfolgen, z.B. in einem Ofen. In jedem Fall führt auch hier die freigesetzte Reaktionswärme dazu, dass der Underfill 222 aufschmilzt, aufreißt und/oder verascht wird und es dadurch zu einer Trennung in die einzelnen Teilelemente 10 und 20a kommt.

Figur 8 zeigt ein weiteres Beispiel für einen Ausschnitt aus einer elektronischen Baugruppe 1, bei der ein diskretes Bauelement 20b auf einem Schaltungsträger 10 aufgebracht ist. Dabei kann es sich insbesondere um ein SMD-Bauelement handeln (SMD für englisch "Surface-mounted device"), welches an zwei Kontaktstellen über zugehörige Lotschichten 220 mit dem Schaltungsträger 10 verbunden ist. In den so ausgebildeten Verbindungsbereichen wird also über die Lotschichten 220 eine stoffschlüssige elektrisch leitende Verbindung vermittelt. Um diese Verbindung im Recycling-Prozess gezielt auftrennen zu können sind die Lotschichten 220 auch hier mit Inseln einer Reaktionsschicht 210 durchsetzt. Ähnlich wie beim vorhergehenden Beispiel kann die exotherme Reaktion in der Reaktionsschicht mit einem Zündpuls gezündet werden und breitet sich dann im jeweiligen Verbindungsbereich auch zwischen den einzelnen Inseln aus. So kann eine gezielte Auftrennung der Lötverbindungen z.B. durch optische oder auch elektrische Zündung bewirkt werden. Zweckmäßig ist hier das Material der Reaktionsschicht so gewählt, dass die Auslösetemperatur oberhalb der relevanten Löttemperatur liegt. Für niedrigschmelzende Lote kann dies mit den oben genannten Materialsystemen erreicht werden.

### Bezugszeichenliste

- 1: Elektronik-Baugruppe
- 10: erstes Teilelement (Schaltungsträger)
- 20: zweites Teilelement (elektronisches Bauelement)
- 20a: Halbleiterchip
- 20b: SMD-Bauelement
- 25: Vergussmittel
- 30: drittes Teilelement (Kühlkörper)
- 100: Verbindungsbereich
- 200: Trennschicht
- 205: Zwischenbereich
- 210: Reaktionsschicht (Multischichtfolie)
- 211: erste Teilschicht
- 212: zweite Teilschicht
- 220: weitere Schicht (Kopplungsschicht)
- 220a: Kopplungsschicht mit vergrößertem Volumen
- 220b: Kopplungsschicht mit Rissbildung
- 220c: geschmolzene bzw. veraschte Kopplungsschicht
- 220d: Kopplungsschicht mit verringerter Haftung
- 221: Bond Bumps
- 222: Underfill
- 230: Lücke
- 300: Zündpuls
- 305: Reaktionsbereich
- 310: zündpuls-leitendes Element (Glasfaser)
- d: Dicke der Reaktionsschicht

## Patentansprüche

1. Elektronik-Baugruppe (1) mit einem ersten Teilelement (10) und einem zweiten Teilelement (20)
und einem Verbindungsbereich (100), in dem die beiden Teilelemente (10,20) miteinander verbunden sind und der zumindest abschnittsweise eine Trennschicht (200) aufweist,
wobei die Trennschicht eine Reaktionsschicht (210) umfasst, die durch Zünden einer exothermen chemischen Reaktion reagieren kann, so dass die exotherme chemische Reaktion in der Trennschicht (200) zu einer Auftrennung der Elektronik-Baugruppe (1) in das erste Teilelement (10) und das zweite Teilelement (20) führt.

2. Elektronik-Baugruppe (1) nach Anspruch 1, bei der die Reaktionsschicht (210) dazu ausgelegt ist, durch einen Zündpuls (300), insbesondere einen optischen Zündpuls, einen elektrischen Zündpuls, einen thermischen Zündpuls, eine chemische bzw. elektrochemische Zündung und/oder eine Zündung durch Kompression, gezündet zu werden.

3. Elektronik-Baugruppe (1) nach Anspruch 2, welche zwischen einer Außenfläche der Elektronik-Baugruppe (1) und der Trennschicht (200) ein lichtleitendes Element (310), ein thermisch leitfähiges Element und/oder eine elektrische Leitung aufweist, um einen Zündpuls (300) von der Außenfläche zur Trennschicht (200) weiterzuleiten.

4. Elektronik-Baugruppe (1) nach einem der vorhergehenden Ansprüche, bei welcher die Reaktionsschicht (210) temperaturstabil bis zu einer Temperatur von wenigstens 200 °C, insbesondere sogar bis zu einer Temperatur von wenigstens 500 °C ist.

5. Elektronik-Baugruppe (1) nach einem der vorhergehenden Ansprüche, bei welcher die Reaktionsschicht (210) Aluminium, Nickel, Titan, Zirconium, Silizium und/oder Palladium umfasst.

6. Elektronik-Baugruppe (1) nach einem der vorhergehenden Ansprüche, bei welcher die Reaktionsschicht (210) eine reaktive Multischichtfolie ist.

7. Elektronik-Baugruppe (1) nach einem der Ansprüche 1 bis 5, bei welcher die Reaktionsschicht (210) zwei Materialkomponenten aufweist, die in Form von Mikropartikeln in der Reaktionsschicht vorliegen.

8. Elektronik-Baugruppe (1) nach einem der vorhergehenden Ansprüche, bei welcher die Trennschicht (200) zusätzlich zu der Reaktionsschicht (210) noch eine weitere Schicht (220) umfasst, die insbesondere als Lotschicht oder als Klebeschicht ausgebildet ist.

9. Elektronik-Baugruppe (1) nach Anspruch 8, bei welcher die Auftrennung in das erste Teilelement (10) und das zweite Teilelement (20) dadurch erreicht werden kann, dass durch Zünden der exothermen chemischen Reaktion die weitere Schicht (220) zum Schmelzen und/oder Aufreißen und/oder zum Veraschen gebracht wird.

10. Elektronik-Baugruppe (1) nach einem der vorhergehenden Ansprüche, bei welcher der Verbindungsbereich (100) ein vollflächiger Verbindungsbereich zwischen den beiden Teilelementen (10,20) ist.

11. Elektronik-Baugruppe (1) nach einem der Ansprüche 1 bis 9, bei welcher der Verbindungsbereich (100) nur einen lokalen Teilbereich einer Hauptfläche des ersten Teilelements (10) ausbildet.

12. Elektronik-Baugruppe (1) nach einem der vorhergehenden Ansprüche, bei welcher der Verbindungsbereich (100) nur in einzelnen lokalen Teilbereichen die Reaktionsschicht (210) aufweist.

13. Elektronik-Baugruppe (1) nach einem der vorhergehenden Ansprüche, bei welcher das erste Teilelement (10) ein Schaltungsträger ist.

14. Elektronik-Baugruppe (1) nach einem der vorhergehenden Ansprüche, bei welcher das zweite Teilelement (20) ein elektronisches Bauelement und/oder ein Kühlkörper und/oder ein Gehäuseelement und/oder ein tragendes Element ist.

15. Verfahren zum Recyceln von wenigstens einer Teilkomponente einer Elektronik-Baugruppe (1) nach einem der vorhergehenden Ansprüche mit einem Trennschritt,
bei dem die Elektronik-Baugruppe (1) durch eine Auftrennung im Bereich der Trennschicht (200) mittels Zünden einer exothermen chemischen Reaktion in der Reaktionsschicht (210) in das erste Teilelement (10) und das zweite Teilelement (20) zerlegt wird.
